# EUROPEAN PATENT APPLICATION

(11) **EP 4 722 797 A2**
(43) Date of publication of application: **08.04.2026**
(21) Application number: 26152966.3
(22) Date of filing: 23.12.2022
(51) Int. Cl.: G02F 1/03

(54) **QUANTUM COMPUTING SYSTEM**

(62) Divisional of application: 22216397.4
(71) Applicant: NKT Photonics A/S, 3460 Birkerød (DK)
(72) Inventor: HENRIKSEN, Martin Romme, 3460 Birkerød (DK)
(74) Representative: Zacco Denmark A/S

(57) **Abstract**

A quantum computing system, comprising: an optical source for generating a continuous-wave, cw, optical carrier signal at a carrier wavelength; a confinement chamber; and optical intensity modulation apparatus comprising; an optical modulator operative to modulate the continuous-wave, cw, optical carrier signal to generate at least one sideband on the optical carrier signal, a radio frequency, RF, signal generator, operative to provide an RF drive signal to the optical modulator; a first optical waveguide grating having a central reflection wavelength corresponding to one of said sideband(s); and optical routing apparatus configured to direct the optical carrier signal and the at least one sideband to the first optical waveguide grating; and to direct a reflected optical signal from the first optical waveguide grating towards an output to form an output optical signal to be delivered to the confinement chamber.

## Description

### Technical Field

The invention relates to a quantum computing system. The invention further relates to an optical intensity modulation apparatus. The invention further relates to a laser system including the optical intensity modulation apparatus. The invention further relates to a system for coherent excitation. The invention further relates to a system for coherent state control of a quantum system.

### Background

Fast optical intensity modulation of optical signals is typically performed using an acousto-optic modulator, AOM, a Mach-Zehnder electro-optic modulator, MZM-EOM, or a semi-conductor optical amplifier, SOA. AOMs have a high extinction ratio and the intensity modulation can be controlled to produce no phase shift to the optical signal (which may be referred to as "phase/amplitude coupling") but have a slow rise time meaning they are not suitable for ultra-fast intensity modulation. MZM-EOMs have a fast rise time, but have a low extinction ratio, meaning they are not suitable for applications requiring amplification of pulse trains having a long dark time, and produce phase/amplitude coupling, meaning they are not suitable for applications requiring precise phase control of the optical signal. SOAs have a high extinction ratio, a rise time significantly faster than AOMs but slower than a MZM-EOM, and produce phase/amplitude coupling.

### Summary

It is an object to provide an improved optical intensity modulation apparatus. It is a further object to provide an improved laser system. It is a further object to provide an improved system for coherent excitation. It is a further object to provide an improved optical system for quantum computing. It is a further object to provide an improved apparatus for coherent state control of a quantum system.

An aspect provides optical intensity modulation apparatus comprising an optical modulator, a radio frequency, RF, signal generator, a first optical waveguide grating and optical routing apparatus. The optical modulator is operative to modulate a continuous-wave, cw, optical carrier signal at a carrier wavelength to generate at least one sideband on the optical carrier signal. The RF signal generator is operative to provide an RF drive signal to the optical modulator. The first optical waveguide grating has a central reflection wavelength corresponding to a said sideband. The optical routing apparatus is configured to direct the optical carrier signal and the at least one sideband to the first optical waveguide grating and to direct a reflected optical signal from the first optical waveguide grating towards an output to form an output optical signal. The RF signal generator is operative to switch the drive signal on and off so as to form an intensity modulated output optical signal.

The optical intensity modulation apparatus may provide a high extinction ratio, fast rise time and independent phase and amplitude control of an optical pulse. Many quantum systems, such as quantum computers, atomic clocks and atom interferometer, require unique amplitude shaped pulses and full control of the optical phase. Furthermore, a high extinction ratio is required for energy efficient amplification of pulse trains with long dark time. The optical intensity modulation apparatus may provide an improvement on these parameters compared to the AOM, MZ-EOM and SOA described above.

In an embodiment, the first optical waveguide grating is a first fibre Bragg grating.

In an embodiment, the first fibre Bragg grating is an apodized fibre Bragg grating having a raised Gaussian reflection profile and constant grating period. This may enable very good sidelobe suppression and a sharp reflection profile, and hence the first FBG is suited for separating signals that are closely spaced in frequency.

In an embodiment, the optical routing apparatus is an optical circulator.

In an embodiment, the optical modulation apparatus further comprises an output optical waveguide grating provided after the optical routing apparatus, i.e. between the optical routing apparatus and the output of the optical intensity modulation apparatus. The output optical waveguide grating has a reflection bandwidth including the carrier wavelength. The output optical waveguide grating may further improve the extinction ratio of the optical modulation apparatus, by further supressing the optical carrier signal.

Preferably, there is substantially no reflection of the optical carrier signal, or of any other generated sidebands than said sideband, back to the optical routing apparatus from the first optical waveguide grating.

In an embodiment, the optical modulator and the optical routing apparatus are arranged along a first optical path, and the optical routing apparatus and the first optical waveguide grating are arranged along a second optical path, where the second optical path does not contain an optical waveguide grating having a central reflection wavelength corresponding to the carrier signal or other generated sidebands than said sideband. The optical carrier signal and other generated sidebands are then transmitted by the first optical waveguide grating, e.g. to an optical dump at the end of the second optical path. Thereby, the output optical signal is only output when the optical modulator generates said sideband.

In an embodiment, the first optical path does not contain other optical waveguide gratings than the first optical waveguide grating.

In an embodiment, the first optical waveguide grating may be arranged in a first optical waveguide which is free of an optical waveguide grating having a central reflection wavelength corresponding to the carrier signal or other generated sidebands than said sideband, such as other optical waveguide gratings than the first optical waveguide grating.

Preferably, any reflection of the optical carrier signal in the first optical waveguide grating towards the output is less than 10 %, such as less than 5 %, such as less than 2 %, such as less than 1 % of the optical carrier signal directed to the first optical waveguide grating.

In an embodiment, the output optical waveguide grating is a further Bragg grating.

In an embodiment, the optical modulation apparatus further comprises a second optical waveguide grating and second optical routing apparatus. The second optical waveguide grating has a central reflection wavelength corresponding to the said sideband. The second optical routing apparatus is configured to direct the reflected optical signal from the first optical waveguide grating to the second optical waveguide grating and to direct a second reflected optical signal from the second optical waveguide grating towards the output. The second optical waveguide grating may further improve the extinction ratio of the optical modulation apparatus.

In an embodiment, the second optical waveguide grating is a second fibre Bragg grating.

In an embodiment, the second fibre Bragg grating is an apodized fibre Bragg grating having a raised Gaussian reflection profile and constant grating period. This may enable very good sidelobe suppression and a sharp reflection profile, and hence the second FBG is suited for separating signals that are closely spaced in frequency.

In an embodiment, the second optical routing apparatus is a second optical circulator.

In an embodiment, the optical modulation apparatus further comprises an output optical waveguide grating provided after the second optical routing apparatus. The output optical waveguide grating has a reflection bandwidth including the carrier wavelength. The output optical waveguide grating may further improve the extinction ratio of the optical modulation apparatus, by further supressing the optical carrier signal.

In an embodiment, the output optical waveguide grating is a further fibre Bragg grating.

In an embodiment, the optical modulator is operative to modulate the cw optical carrier signal to generate a lower sideband and an upper sideband on the optical carrier signal. The first optical waveguide grating has a central reflection wavelength corresponding to one of the lower sideband and the upper sideband. The optical modulator may be operative to modulate the cw optical carrier signal to generate only the lower and upper sidebands and not any further sidebands on the optical carrier signal. This is advantageous over apparatuses which generates further sidebands, since the optical power of the modulated carrier signal then is maintained in only two side bands rather than being distributed to several sidebands.

In an embodiment, the output optical waveguide grating has a reflection bandwidth including the carrier wavelength and the other of the upper sideband or the lower sideband. The output optical waveguide grating may further improve the extinction ratio of the optical modulation apparatus, by further supressing the optical carrier signal and the other of the upper sideband or the lower sideband.

In an alternative embodiment, the optical modulator is a single sideband, SSB, modulator operative to modulate the cw optical carrier signal to generate a single sideband on the optical carrier signal. The optical modulator may be operative to modulate the cw optical carrier signal to generate only the single sideband and not any further sidebands on the optical carrier signal. This is advantageous over apparatuses which generates two or more further sidebands, since the optical power of the modulated carrier signal then is maintained in only the single sideband rather than being distributed to several sidebands. In some embodiments, the optical modulator comprises a serrodyne modulator. The first optical waveguide grating has a central reflection wavelength corresponding to the generated sideband.

In an embodiment, the RF signal has a frequency of up to 100 GHz, such as a frequency in the range 1 GHz to 20 GHz.

Corresponding embodiments and advantages apply to the laser system, quantum computing system and system for coherent excitation described below.

In an embodiment, the RF signal generator is operative to provide an RF drive signal comprising RF signal pulses having a compensating pulse shape such that the at least one sideband comprises optical pulses having the compensating pulse shape. The compensating pulse shape is configured to compensate for an optical amplifier non-uniform gain response in the time domain. The optical modulation apparatus may thus be used to deliver a pre-shaped optical pulse to an optical amplifier, enabling a pulse of a desired pulse shape to be output from the optical amplifier.

An aspect provides a laser system comprising an optical source and optical intensity modulation apparatus. The optical source is for generating a continuous-wave, cw, optical carrier signal at a carrier wavelength. The optical intensity modulation apparatus comprises an optical modulator, a radio frequency, RF, signal generator, a first optical waveguide grating and optical routing apparatus. The optical modulator is operative to modulate a continuous-wave, cw, optical carrier signal at a carrier wavelength to generate at least one sideband on the optical carrier signal. The RF signal generator is operative to provide an RF drive signal to the optical modulator. The first optical waveguide grating has a central reflection wavelength corresponding to a said sideband. The optical routing apparatus is configured to direct the optical carrier signal and the at least one sideband to the first optical waveguide grating and to direct a reflected optical signal from the first optical waveguide grating towards an output to form an output optical signal. The RF signal generator is operative to switch the drive signal on and off so as to form an intensity modulated output optical signal.

In an embodiment, the RF signal generator is operative to provide an RF drive signal comprising RF signal pulses having a compensating pulse shape such that the at least one sideband comprises optical pulses having the compensating pulse shape. The compensating pulse shape is configured to compensate for an optical amplifier non-uniform gain response in the time domain. The laser may thus be used to deliver a pre-shaped optical pulse to an optical amplifier, enabling a pulse of a desired pulse shape to be output from the optical amplifier.

In an alternative embodiment, the optical intensity modulation apparatus further comprises an optical amplifier and an optical detector. The optical amplifier is configured to amplify the intensity modulated output optical signal from the optical intensity modulation apparatus. The optical amplifier has a non-uniform gain response in the time domain. The optical detector is configured to detect a pulse shape of the intensity modulated output optical signal after amplification by the optical amplifier and to generate an output signal indicative of the detected pulse shape. The RF signal generator comprises interface circuitry, at least one processor and memory comprising instructions executable by said processor whereby the RF signal generator is operative as follows. To receive an output signal indicative of a detected pulse shape from the optical detector. To determine a difference between the detected pulse shape and a target pulse shape. To determine a compensating pulse shape configured to at least partly compensate for said difference. To generate the RF drive signal comprising RF signal pulses having the compensating pulse shape, such that the at least one sideband comprises optical pulses having the compensating pulse shape. The optical modulation apparatus may thus be used to deliver a pre-shaped optical pulse to the optical amplifier, enabling a pulse of a desired pulse shape to be output from the optical amplifier.

Corresponding embodiments also apply to the quantum computing system and the system for coherent excitation described below.

An aspect provides a quantum computing system comprising an optical source, optical intensity modulation apparatus and a confinement chamber. The optical source is for generating a continuous-wave, cw, optical carrier signal at a carrier wavelength. The optical intensity modulation apparatus comprises an optical modulator, a radio frequency, RF, signal generator, a first optical waveguide grating and optical routing apparatus. The optical modulator is operative to modulate a continuous-wave, cw, optical carrier signal at a carrier wavelength to generate at least one sideband on the optical carrier signal. The RF signal generator is operative to provide an RF drive signal to the optical modulator. The first optical waveguide grating has a central reflection wavelength corresponding to a said sideband. The optical routing apparatus is configured to direct the optical carrier signal and the at least one sideband to the first optical waveguide grating and to direct a reflected optical signal from the first optical waveguide grating towards an output to form an output optical signal to be delivered to the confinement chamber. The RF signal generator is operative to switch the drive signal on and off so as to form an intensity modulated output optical signal.

An aspect provides system for coherent excitation comprising an optical source, optical intensity modulation apparatus and an excitation chamber. The optical source is for generating a continuous-wave, cw, optical carrier signal at a carrier wavelength. The optical intensity modulation apparatus comprises an optical modulator, a radio frequency, RF, signal generator, a first optical waveguide grating and optical routing apparatus. The optical modulator is operative to modulate a continuous-wave, cw, optical carrier signal at a carrier wavelength to generate at least one sideband on the optical carrier signal. The RF signal generator is operative to provide an RF drive signal to the optical modulator. The first optical waveguide grating has a central reflection wavelength corresponding to a said sideband. The optical routing apparatus is configured to direct the optical carrier signal and the at least one sideband to the first optical waveguide grating and to direct a reflected optical signal from the first optical waveguide grating towards an output to form an output optical signal to be delivered to the excitation chamber. The RF signal generator is operative to switch the drive signal on and off so as to form an intensity modulated output optical signal.

An aspect provides a system for coherent state control of a quantum system. The apparatus comprises an optical source, optical intensity modulation apparatus and an interaction chamber for a quantum system. The optical source is for generating a continuous-wave, cw, optical carrier signal at a carrier wavelength. The optical intensity modulation apparatus comprises an optical modulator, a radio frequency, RF, signal generator, a first optical waveguide grating and optical routing apparatus. The optical modulator is operative to modulate a continuous-wave, cw, optical carrier signal at a carrier wavelength to generate at least one sideband on the optical carrier signal. The RF signal generator is operative to provide an RF drive signal to the optical modulator. The first optical waveguide grating has a central reflection wavelength corresponding to a said sideband. The optical routing apparatus is configured to direct the optical carrier signal and the at least one sideband to the first optical waveguide grating and to direct a reflected optical signal from the first optical waveguide grating towards an output to form an output optical signal to be delivered to the interaction chamber. The RF signal generator is operative to switch the drive signal on and off so as to form an intensity modulated output optical signal.

### Brief Description of the drawings

Figures 1 to 7 and 14 are block diagrams illustrating embodiments of optical intensity modulation apparatus;
Figures 8 to 10 are block diagrams illustrating embodiments of laser systems;
Figure 11 is a block diagram illustrating an embodiment of a system for coherent excitation of atoms or ions;
Figure 12 is a block diagram illustrating an embodiment of a quantum computing system; and
Figure 13 is a block diagram illustrating an embodiment of a system for coherent state control of a quantum system.

### Detailed description

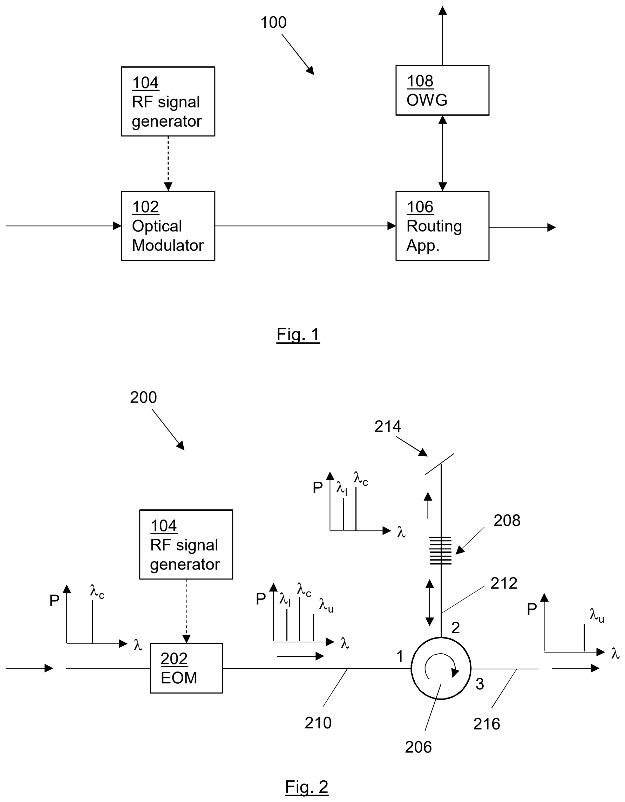

Referring to Figure 1, an embodiment provides optical intensity modulation apparatus 100 comprising an optical modulator 102, a radio frequency, RF, signal generator 104, a first optical waveguide grating 108 and optical routing apparatus 106.

The RF signal generator is operative to provide an RF drive signal to the optical modulator

The optical modulator is arranged in a first optical path to receive a continuous-wave, cw, optical carrier signal at a carrier wavelength. The optical modulator is operative to modulate the optical carrier signal to generate at least one sideband on the optical carrier signal.

The first optical waveguide grating, OWG, 108 is arranged in a second optical path connecting first optical waveguide grating to the optical routing apparatus and has a central reflection wavelength corresponding to a said sideband.

The optical routing apparatus 106 is configured to direct the optical carrier signal and the at least one sideband along the second optical path to the first optical waveguide grating. The optical routing apparatus 106 is configured also to direct a reflected optical signal from the first optical waveguide grating back along the second optical path towards a third optical path to an output to form an output optical signal. The optical waveguide with the first optical waveguide grating is free of a waveguide grating with a central reflection wavelength corresponding to said carrier wavelength, such that the carrier signal is not reflected towards the output and does not for part of the output optical signal. Also, the optical waveguide is free of a grating with a central reflection wavelength corresponding to any other generated sideband.

The RF signal generator is operative to switch the drive signal on and off; when the drive signal is on, the at least one sideband is generated, and when the drive signal is off, no sideband is generated. By switching the drive signal on and off an intensity modulated output optical signal is formed.

In an embodiment, the RF signal has a frequency of up to 100 GHz, such as a frequency in the range 1 GHz to 20 GHz.

In an embodiment, the RF signal generator 104 is a high speed arbitrary waveform generator, AWG.

In an embodiment, illustrated in Figure 2, the optical modulator is an electro-optic modulator, EOM, 202, the first optical waveguide grating is a first fibre Bragg grating, FBG, 208 and the optical routing apparatus is an optical circulator 206.

The RF signal generator is operative to provide an RF drive signal to the EOM.

The EOM is arranged to receive a cw optical carrier signal at a carrier wavelength, λ_{c}. The EOM is driven by the RF drive signal from the RF signal generator 104 to phase modulate the cw optical carrier signal. The EOM is operative to modulate the optical carrier signal to generate an upper sideband at an upper sideband wavelength, λᵤ, and a lower sideband at a lower sideband wavelength, λₗ, on the optical carrier signal. The RF drive signal is at a frequency, f, therefore the sidebands are spaced from the carrier wavelength by an optical frequency offset, f.

An output of the EOM is connected to a first port, 1, of the optical circulator by a first optical fibre 210. The optical circulator is configured to route optical signals from the first port to a second port, 2, to which a second optical fibre 212 containing the first FBG 208 is connected. The optical carrier signal, upper sideband and lower sideband output from the EOM are thus directed by the optical circulator to the first FBG.

The first FBG 208 has a reflection profile including a central reflection wavelength which, in this example, corresponds to the upper sideband. A defined percentage of the upper sideband is reflected by the first FBG, depending on the reflectivity of the first FBG; this is typically in the range 90 % to 99 %. The optical carrier signal and the lower sideband are transmitted by the first FBG towards an optical dump 214 at an end of the optical fibre. Depending on the reflection profile of the first FBG, a small percentage (for example 0.01 % to 1 %) of the optical carrier signal and the lower sideband may be reflected by the FBG.

The optical circulator 206 is configured to route an optical signal reflected from the first FBG from the second port, 2, to a third port, 3, into an output optical fibre 216 to form an output optical signal.

It will be appreciated that where an optical circulator is described as being used a four-port optical coupler may alternatively be used, preferably a 50:50 optical coupler.

The RF signal generator is operative to switch the drive signal on and off; when the drive signal is on, the upper and lower sidebands are generated, and when the drive signal is off, no sidebands are generated. In this example, when the drive signal is on, the upper sideband is present and is reflected by the first FBG and directed towards the output, as an output optical signal. By switching the drive signal on and off an intensity modulated output optical signal at the upper sideband wavelength is formed.

In an embodiment, the first FBG 208 is an apodized FBG with a raised Gaussian reflection profile and constant grating period. The first FBG 208 may be mounted on an aluminium substrate with temperature sensor and piezo actuators to control and stabilize its central reflection wavelength.

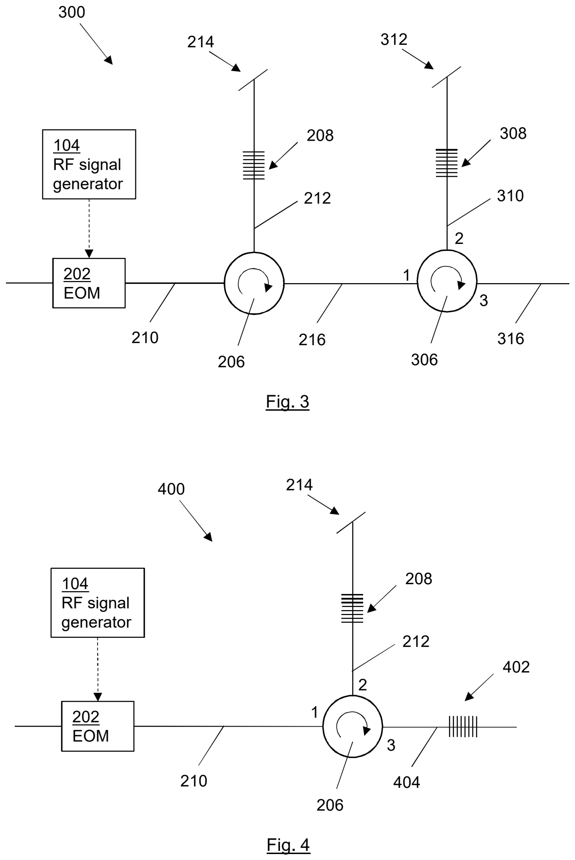

In an embodiment, illustrated in Figure 3, the optical intensity modulation apparatus 300 additionally comprises a second optical waveguide grating and second optical routing apparatus.

The second optical waveguide grating in this example is a second FBG 308. The second optical routing apparatus in this example is a second optical circulator 306.

The third port, 3, of the optical circulator 206 is connected to a first port, 1, of the second optical circulator by the output optical fibre 216 of the optical circulator 206. The second optical circulator is configured to route optical signals from the first port to a second port, 2, to which a third optical fibre 310 containing the second FBG 308 is connected. The optical signal reflected from the first FBG 208, comprising the reflected portion of the upper sideband and, potentially, the small percentage of the optical carrier signal and the lower sideband are thus directed by the second optical circulator to the second FBG.

The second FBG 308 has a central reflection wavelength which, in this example, corresponds to the upper sideband. The second FBG 308 may have substantially the same reflection profile as the first FBG 208.

A defined percentage of the upper sideband is reflected by the second FBG, depending on the reflectivity of the second FBG; this is typically in the range 90 % to 99 %. The optical carrier signal and the lower sideband in the optical signal reflected from the first FBG 208 are transmitted by the second FBG towards a second optical dump 312 at an end of the third optical fibre 310. Depending on the reflection profile of the second FBG, a small percentage (for example 0.01 % to 1 %) of the optical carrier signal and the lower sideband may be reflected by the second FBG.

The second optical circulator 306 is configured to route an optical signal reflected from the second FBG 308 from the second port, 2, to a third port, 3, into an output optical fibre 316 to form an output optical signal.

In an embodiment, the first FBG 208 and the second FBG 308 are apodized FBGs with a raised Gaussian reflection profile and constant grating period. The first FBG 208 and the second FBG 308 may be mounted on aluminium substrates with temperature sensor and piezo actuators to control and stabilize their central reflection wavelengths.

In an embodiment, illustrated in Figure 4, the optical intensity modulation apparatus 400 additionally comprises an output optical waveguide grating, which in this example is a further FBG 402.

As described above, the first FBG 208 has a reflection profile including a central reflection wavelength which, in this example, corresponds to the upper sideband. A defined percentage of the upper sideband is reflected by the FBG 208, depending on the reflectivity of the first FBG 208. Depending on the reflection profile of the first FBG, a small percentage (for example 0.01 % to 1 %) of the optical carrier signal and the lower sideband are reflected by the first FBG 208.

The output FBG 402 has a reflection bandwidth including the carrier wavelength and the lower sideband wavelength.

The output FBG 402 is provided in a third optical fibre 404 connected to the third port 3 of the optical circulator 206. The output FBG therefore receives the optical signal reflected by the FBG 208. The output FBG 402 transmits the upper sideband received from the first FBG 208 to form the output optical signal and reflects a defined percentage of the optical carrier signal and the lower sideband, depending on the reflectivity of the output FBG; this is typically in the range 90 % to 99 %.

In an embodiment, the optical modulation apparatus 300, illustrated in Figure 3, additionally comprises an output optical waveguide grating, for example a further FBG 402 as described above, after the second optical circulator 306.

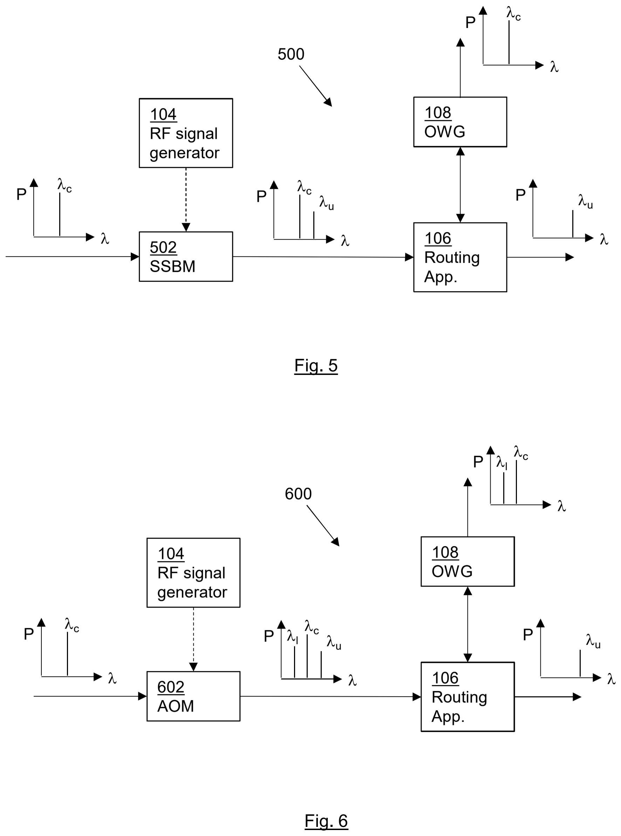

An embodiment provides optical modulation apparatus 500, illustrated in Figure 5. In this embodiment the optical modulator is a single sideband modulator, SSBM, 502. The SSBM is operative to modulate the cw optical carrier signal to generate a single sideband, for example the upper sideband, on the optical carrier signal.

The first optical waveguide grating, OWG, 108 has a central reflection wavelength corresponding to the generated sideband, in this example the upper sideband.

An embodiment provides optical modulation apparatus 600, illustrated in Figure 6. In this embodiment the optical modulator is an acousto-optic modulator, AOM, 602.

The AOM 602 is arranged to receive a cw optical carrier signal at a carrier wavelength, λ_{c}. The AOM is driven by the RF drive signal from the RF signal generator 104. The AOM is operative to modulate the optical carrier signal to generate an upper sideband at an upper sideband wavelength, λᵤ, and a lower sideband at a lower sideband wavelength, λₗ, on the optical carrier signal. The RF drive signal is at a frequency, f, therefore the sidebands are spaced from the carrier wavelength by an optical frequency offset, f.

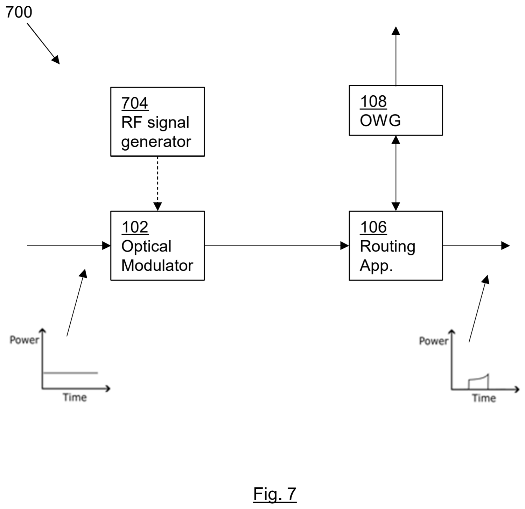

An embodiment provides optical modulation apparatus 700, illustrated in Figure 7. In this embodiment the RF signal generator 704 is operative to provide an RF drive signal comprising RF signal pulses having a compensating pulse shape. The RF drive signal thus causes the at least one sideband generated by the optical modulator 104 to comprise optical pulses having the compensating pulse shape. The compensating pulse shape is configured to compensate for an optical amplifier non-uniform gain response in the time domain.

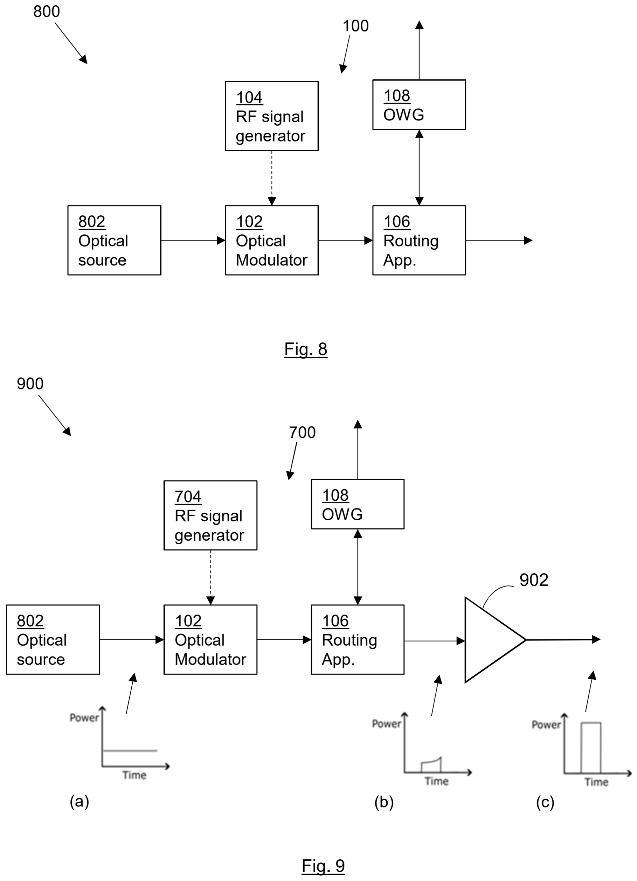

Referring to Figure 8, an embodiment provides a laser system 800 comprising an optical source 802 and optical intensity modulation apparatus 100, as described above.

The optical source is for generating a continuous-wave, cw, optical carrier signal at a carrier wavelength.

Referring to Figure 9, an embodiment provides a laser system 900 comprising an optical source 802, optical intensity modulation apparatus 700, as described above, and an optical amplifier 902.

The optical source is for generating a continuous-wave, cw, optical carrier signal at a carrier wavelength, as illustrated in inset graph (a).

The optical amplifier is configured to amplify the intensity modulated output optical signal from the optical intensity modulation apparatus 700. The optical amplifier has a non-uniform gain response in the time domain.

The RF signal generator 704 is operative to provide an RF drive signal comprising RF signal pulses having a compensating pulse shape. The RF drive signal thus causes the at least one sideband generated by the optical modulator 704 to comprise optical pulses having the compensating pulse shape, as illustrated in inset graph (b). The compensating pulse shape is configured to compensate for the non-uniform gain response in the time domain of the optical amplifier 902. The optical signal output from the optical amplifier thus comprises optical pulses having a desired pulse shape, as illustrated in inset graph (c).

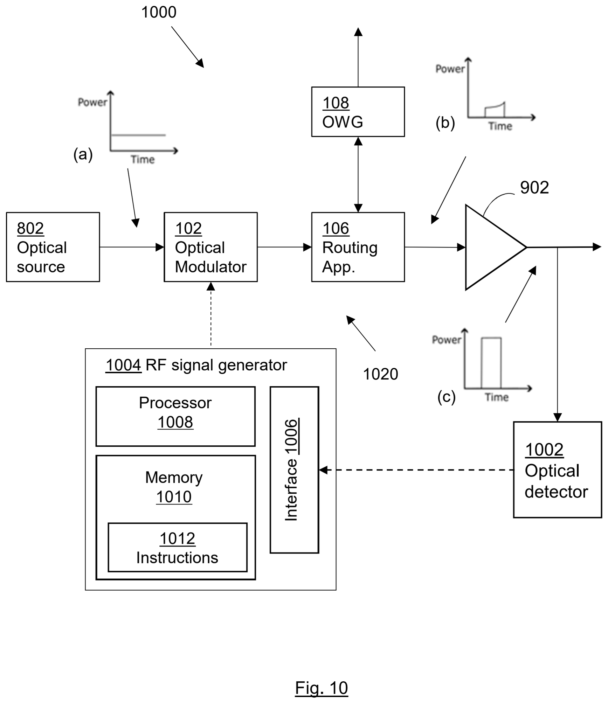

Referring to Figure 10, an embodiment provides a laser system 1000 comprising an optical source 802, optical intensity modulation apparatus 1020, an optical amplifier 902 and an optical detector 1002.

The optical source is for generating a continuous-wave, cw, optical carrier signal at a carrier wavelength, as illustrated in inset graph (a).

Similarly to the apparatus 100 described above, the optical intensity modulation apparatus 1020 comprises an optical modulator 102, optical routing apparatus 106, an optical waveguide grating, OWG, 108. The optical intensity modulation apparatus 1020 also comprises an RF signal generator 1004, having a structure and operation as described below.

The optical amplifier 902 is configured to amplify the intensity modulated output optical signal from the optical intensity modulation apparatus 1020. The optical amplifier has a non-uniform gain response in the time domain.

The optical detector 1002 is configured to detect a pulse shape of the intensity modulated output optical signal after amplification by the optical amplifier. The optical detector is additionally configured to generate an output signal indicative of the detected pulse shape.

The RF signal generator 1004 is operative to provide an RF drive signal comprising RF signal pulses having a compensating pulse shape.

The RF signal generator comprises interface circuitry 1006, a processor 1008 and memory 1010. The memory comprises instructions 1012 executable by the processor whereby the RF signal generator is operative as follows.

The RF signal generator is operative to receive an output signal from the optical detector; the output signal is indicative of a pulse shape detected by the optical detector.

The RF signal generator is operative to determine a difference between the detected pulse shape and a target pulse shape, and to determine a compensating pulse shape configured to at least partly compensate for that difference.

The RF signal generator is operative to generate the RF drive signal comprising RF signal pulses. The RF signal pulses have the compensating pulse shape. The RF drive signal thus causes the at least one sideband generated by the optical modulator 102 to comprise optical pulses having the compensating pulse shape, as illustrated in inset graph (b). The compensating pulse shape is configured to compensate for the non-uniform gain response in the time domain of the optical amplifier 902. The optical signal output from the optical amplifier thus comprises optical pulses having a desired pulse shape, as illustrated in inset graph (c).

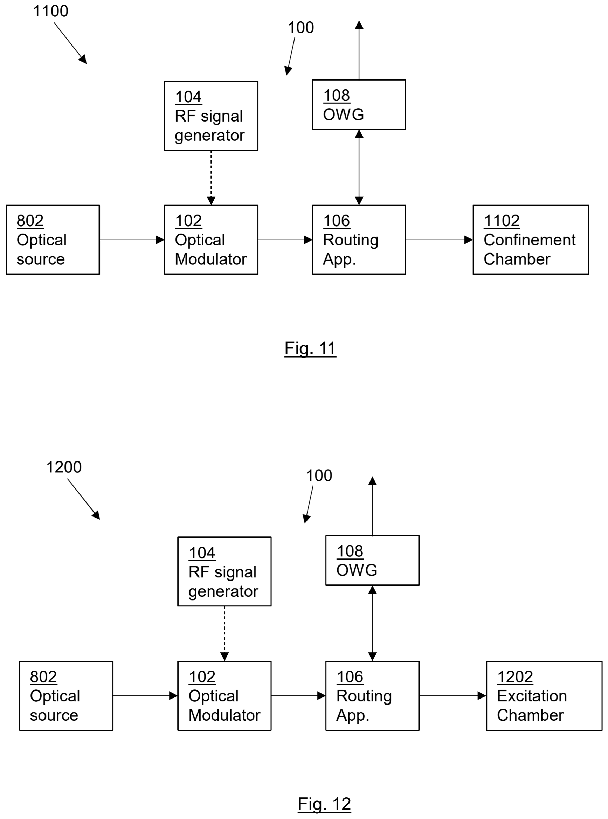

Referring to Figure 11, an embodiment provides a quantum computing system 1100, comprising optical source 802, optical intensity modulation apparatus 100, and a confinement chamber 1102.

The optical source is for generating a continuous-wave, cw, optical carrier signal at a carrier wavelength.

The optical intensity modulation apparatus 100 is as described above. It will be understood that optical intensity modulation apparatus 700 may alternatively be used.

The confinement chamber may be an ion trap for confining ions. The output optical signal from the optical intensity modulation apparatus 100 is delivered to the ion trap to interact with trapped ions, for example for storing qubits in stable electronic states of the ions or inducing coupling between qubit states.

The confinement chamber may alternatively be an atom trap for confining atoms. The output optical signal from the optical intensity modulation apparatus 100 is delivered to the atom trap to interact with trapped atoms.

It will be understood that optical intensity modulation apparatus 700 may alternatively be used.

Optical intensity modulation apparatus 1020 as described above may also be used.

Referring to Figure 12, an embodiment provides a system 1200 for coherent excitation, comprising an optical source 802, optical intensity modulation apparatus 100, and an excitation chamber 1202.

The optical source is for generating a continuous-wave, cw, optical carrier signal at a carrier wavelength.

The optical intensity modulation apparatus 100 is as described above. It will be understood that optical intensity modulation apparatus 700 may alternatively be used.

The output optical signal from the optical intensity modulation apparatus 100 is delivered to the excitation chamber to interact with a sample in the excitation chamber. For example, the sample may comprise atoms, such as Caesium, Strontium or Ytterbium atoms, to undergo Rydberg excitation. In an alternative example, the excitation chamber is for performing Ramsey spectroscopy on the sample.

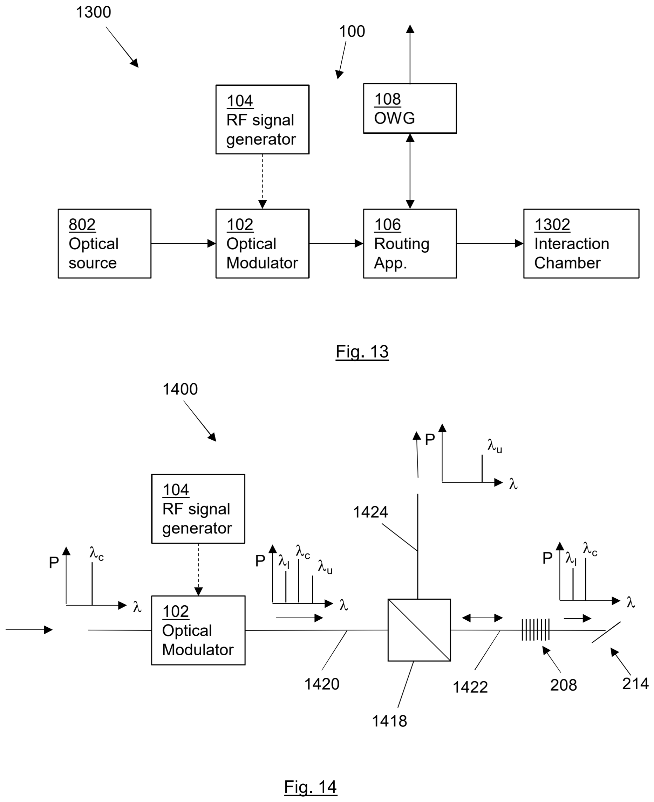

Referring to Figure 13, an embodiment provides a system 1300 for coherent state control of a quantum system. The apparatus 1300 comprises an optical source 802, optical intensity modulation apparatus 100, and an interaction chamber 1302 for a quantum system.

The optical source is for generating a continuous-wave, cw, optical carrier signal at a carrier wavelength.

The optical intensity modulation apparatus 100 is as described above. It will be understood that optical intensity modulation apparatus 700 may alternatively be used.

The output optical signal from the optical intensity modulation apparatus 100 is delivered to the interaction chamber to interact with one or more particles, for example an atom or atoms, an ion or ions, to control the quantum state of the one or more particles.

In an embodiment, the quantum system is an atomic clock.

In an embodiment, the quantum system is an atomic interferometer.

In an embodiment, the quantum system is a quantum gravimeter.

Referring to Figure 14, an embodiment provides optical intensity modulation apparatus 1400 comprising an optical modulator 102, a radio frequency, RF, signal generator 104, a first optical waveguide grating 208. In this embodiment, the optical routing apparatus is a beam splitter 1418. The RF signal generator is operative to provide an RF drive signal to the optical modulator.

The optical modulator 102 is arranged to receive a cw optical carrier signal at a carrier wavelength, λ_{c}. The optical modulator is driven by the RF drive signal from the RF signal generator 104 to phase modulate the cw optical carrier signal. The optical modulator is operative to modulate the optical carrier signal to generate an upper sideband at an upper sideband wavelength, λᵤ, and a lower sideband at a lower sideband wavelength, λₗ, on the optical carrier signal. The RF drive signal is at a frequency, f, therefore the sidebands are spaced from the carrier wavelength by an optical frequency offset, f.

An output of the optical modulator follows a first optical path 1420 of the optical intensity modulation apparatus to the optical beam splitter 1418. The optical beam splitter is arranged to route optical signals from the first optical path to a second optical path 1422 in which the first optical waveguide grating 208 is arranged. The optical carrier signal, upper sideband and lower sideband output from the optical modulator are thus directed by the optical beam splitter to the first optical waveguide grating.

The first optical waveguide grating 208 has a reflection profile including a central reflection wavelength which, in this example, corresponds to the upper sideband. A defined percentage of the upper sideband is reflected by the first optical waveguide grating, depending on the reflectivity of the first optical waveguide grating; this is typically in the range 90 % to 99 %. The optical carrier signal and the lower sideband are transmitted by the first optical waveguide grating towards an optical dump 214 at an end of the second optical path. Depending on the reflection profile of the first optical waveguide grating, a small percentage (for example 0.01 % to 1 %) of the optical carrier signal and the lower sideband may be reflected by the optical waveguide grating.

The optical beam splitter 206 is configured to route an optical signal reflected from the first optical waveguide grating along the second optical path, to a third optical path 1424 to form an output optical signal.

It will be appreciated that the optical paths at least partly may be defined by optical waveguides, such as optical fibres. The optical paths may at least partly may be defined by free-space optics.

The RF signal generator is operative to switch the drive signal on and off; when the drive signal is on, the upper and lower sidebands are generated, and when the drive signal is off, no sidebands are generated. In this example, when the drive signal is on, the upper sideband is present and is reflected by the first optical waveguide grating and directed towards the output, as an output optical signal. By switching the drive signal on and off an intensity modulated output optical signal at the upper sideband wavelength is formed.

In an embodiment, the first optical waveguide grating 208 is an apodized optical waveguide grating with a raised Gaussian reflection profile and constant grating period. The first optical waveguide grating 208 may be mounted on an aluminium substrate with temperature sensor and piezo actuators to control and stabilize its central reflection wavelength.

### List of items

1. Optical intensity modulation apparatus (100, 200, 300, 400, 500, 600, 700) comprising:
   an optical modulator (102, 202, 502, 602) operative to modulate a continuous-wave, cw, optical carrier signal at a carrier wavelength to generate at least one sideband on the optical carrier signal;
   a radio frequency, RF, signal generator (104, 704) operative to provide an RF drive signal to the optical modulator;
   a first optical waveguide grating (108, 208) having a central reflection wavelength corresponding to a said sideband; and
   optical routing apparatus (106, 206) configured to direct the optical carrier signal and the at least one sideband to the first optical waveguide grating and to direct a reflected optical signal from the first optical waveguide grating towards an output to form an output optical signal,
   wherein the RF signal generator is operative to switch the drive signal on and off so as to form an intensity modulated output optical signal.
2. The apparatus of item 1, wherein the first optical waveguide grating is a first fibre Bragg grating (208).
3. The apparatus of item 2, wherein the first fibre Bragg grating is an apodized fibre Bragg grating having a raised Gaussian reflection profile and constant grating period.
4. The apparatus of any one of items1 to 3, wherein the optical routing apparatus is an optical circulator (206).
5. The apparatus of any one of items 1 to 4, comprising an output optical waveguide grating (402) provided after the optical routing apparatus, wherein the output optical waveguide grating has a reflection bandwidth including the carrier wavelength.
6. The apparatus of any one of items 1 to 5, wherein the optical modulator and the optical routing apparatus are arranged along a first optical path and the optical routing apparatus and the first waveguide grating are arranged along a second optical path, where the second optical path does not contain an optical waveguide grating having a central reflection wavelength corresponding to the carrier signal or other generated sidebands than said sideband.
7. The apparatus of any one of items 1 to 6, further comprising:
   a second optical waveguide grating (308) having a central reflection wavelength corresponding to the said sideband; and
   second optical routing apparatus (306) configured to direct the reflected optical signal from the first optical waveguide grating to the second optical waveguide grating and to direct a second reflected optical signal from the second optical waveguide grating towards the output.
8. The apparatus of item 7, wherein the second optical waveguide grating is a second fibre Bragg grating (308).
9. The apparatus of item 8, wherein the second fibre Bragg grating is an apodized fibre Bragg grating having a raised Gaussian reflection profile and constant grating period.
10. The apparatus of any one of items 7 to 9, wherein the second optical routing apparatus is a second optical circulator (306).
11. The apparatus of any one of items 7 to 10, further comprising an output optical waveguide grating (402) provided after the second optical routing apparatus, wherein the output optical waveguide grating has a reflection bandwidth including the carrier wavelength.
12. The apparatus of item 5 or item 11, wherein the output optical waveguide grating is a further fibre Bragg grating (402).
13. The apparatus of any one of items 1 to 12, wherein:
   the optical modulator (102, 602) is operative to modulate the cw optical carrier signal to generate a lower sideband and an upper sideband on the optical carrier signal; and
   the first optical waveguide grating has a central reflection wavelength corresponding to one of the lower sideband and the upper sideband.
14. The apparatus of item 13, when dependent on any one of items 5, 11 or 12, wherein the output optical waveguide grating (402) has a reflection bandwidth including the carrier wavelength and the other of the upper sideband or the lower sideband.
15. The apparatus of any one of items 1 to 12, wherein:
   the optical modulator is a single sideband, SSB, modulator (502) operative to modulate the cw optical carrier signal to generate a single sideband on the optical carrier signal; and
   the first optical waveguide grating (108) has a central reflection wavelength corresponding to the generated sideband.
16. The apparatus of any one of items 1 to 15, wherein the RF signal has a frequency of up to 100 GHz, such as a frequency in the range 1 GHz to 20 GHz.
17. The apparatus of any one of items 1 to 16, wherein the RF signal generator (704) is operative to provide an RF drive signal comprising RF signal pulses having a compensating pulse shape such that the at least one sideband comprises optical pulses having the compensating pulse shape, wherein the compensating pulse shape is configured to compensate for an optical amplifier non-uniform gain response in the time domain.
18. A laser system (800, 900, 1000) comprising:
   an optical source (802) for generating a continuous-wave, cw, optical carrier signal at a carrier wavelength; and
   optical intensity modulation apparatus (100, 700) according to any one of items 1 to 16.
19. A quantum computing system (1100), comprising:
   an optical source (802) for generating a continuous-wave, cw, optical carrier signal at a carrier wavelength;
   optical intensity modulation apparatus (100) according to any one of items 1 to 14; and
   a confinement chamber (1102).
20. A system (1200) for coherent excitation comprising:
   an optical source (802) for generating a continuous-wave, cw, optical carrier signal at a carrier wavelength;
   optical intensity modulation apparatus (100) according to any one of items 1 to 16; and
   an excitation chamber (1202).
21. A system (1300) for coherent state control of a quantum system, the system (1300) comprising:
   an optical source (802) for generating a continuous-wave, cw, optical carrier signal at a carrier wavelength;
   optical intensity modulation apparatus (100) according to any one of items 1 to 16; and
   an interaction chamber (1302) for a quantum system.
22. A system according to any one of items 17 to 20, wherein the optical intensity modulation apparatus (1020) is according to any one of items 1 to 15 and further comprises:
   an optical amplifier (902) configured to amplify the intensity modulated output optical signal from the optical intensity modulation apparatus, the optical amplifier having a non-uniform gain response in the time domain; and
   an optical detector (1002) configured to detect a pulse shape of the intensity modulated output optical signal after amplification by the optical amplifier and to generate an output signal indicative of the detected pulse shape;
   and wherein the RF signal generator (1004) comprises interface circuitry (1006), at least one processor (1008) and memory (1010) comprising instructions (1012) executable by said processor whereby the RF signal generator is operative to:
      - receive an output signal indicative of a detected pulse shape from the optical detector;
      - determine a difference between the detected pulse shape and a target pulse shape;
      - determine a compensating pulse shape configured to at least partly compensate for said difference; and
      - generate the RF drive signal comprising RF signal pulses having the compensating pulse shape, such that the at least one sideband comprises optical pulses having the compensating pulse shape.

## Claims

1. A quantum computing system, comprising:
an optical source for generating a continuous-wave, cw, optical carrier signal at a carrier wavelength;
a confinement chamber; and
optical intensity modulation apparatus comprising;
an optical modulator operative to modulate the continuous-wave, cw, optical carrier signal to generate at least one sideband on the optical carrier signal,
a radio frequency, RF, signal generator, operative to provide an RF drive signal to the optical modulator;
a first optical waveguide grating having a central reflection wavelength corresponding to one of said sideband(s); and
optical routing apparatus configured to direct the optical carrier signal and the at least one sideband to the first optical waveguide grating; and to direct a reflected optical signal from the first optical waveguide grating towards an output to form an output optical signal to be delivered to the confinement chamber.

2. The quantum computing system as claimed in claim 1, wherein the confinement chamber is an ion trap for confining ions.

3. The quantum computing system as claimed in claim 2, wherein the optical intensity modulation apparatus is configured to deliver the output optical signal to the ion trap to interact with trapped ions.

4. The quantum computing system as claimed in any one of claims 2 to 3, wherein the ion trap is suitable for storing qubits in stable electronic states.

5. The quantum computing system as claimed in claim 4, wherein the output optical signal is suitable for inducing coupling between qubit states.

6. The quantum computing system as claimed in claim 1, wherein the confinement chamber is an atom trap for confining atoms.

7. The quantum computing system as claimed in claim 6, wherein the optical intensity modulation apparatus is configured to deliver the output optical signal to the atom trap to interact with trapped atoms.

8. The quantum computing system as claimed in any one of claims 1 to 7, wherein the RF signal generator is operative to switch the drive signal on and off so as to form an intensity modulated output optical signal.

9. The quantum computing system as claimed in any one of claims 1 to 8, wherein the RF signal generator is operative to provide an RF drive signal comprising RF signal pulses having a compensating pulse shape, wherein the at least one sideband comprises optical pulses having the compensating pulse shape.

10. The quantum computing system as claimed in claim 9, wherein the compensating pulse shape is configured to compensate for an optical amplifier non-uniform gain response in the time domain.

11. The quantum computing system as claimed in any one of claims 1 to 10, wherein the optical modulation apparatus is configured to deliver a pre-shaped optical pulse to an optical amplifier.

12. The quantum computing system as claimed in any one of claims 1 to 11, wherein the optical intensity modulation apparatus further comprises an optical amplifier and an optical detector, wherein the optical detector is configured to detect a pulse shape of the intensity modulated output optical signal after amplification by the optical amplifier and to generate an output signal indicative of the detected pulse shape.

13. The quantum computing system as claimed in any one of claims 1 to 12, wherein the RF signal generator is an arbitrary waveform generator, AWG.

14. The quantum computing system as claimed in any one of claims 1 to 13, wherein the first optical waveguide grating is a first fibre Bragg grating mounted on an aluminium substrate with temperature sensor and piezo actuators.

15. The quantum computing system as claimed in any one of claims 1 to 14, wherein the first optical waveguide grating is a first fibre Bragg grating suited for separating signals that are closely spaced in frequency.

16. The quantum computing system as claimed in any one of claims 1 to 15, wherein the optical intensity modulation apparatus is configured to provide a high extinction ratio, fast rise time and independent phase and amplitude control of an optical pulse.
